# EUROPÄISCHE PATENTSCHRIFT

(11) **EP 0 589 276 B1**
(45) Veröffentlichungstag und Bekanntmachung des Hinweises auf die Patenterteilung: **13.03.1996**
(21) Anmeldenummer: 93114274.9
(22) Anmeldetag: 06.09.1993
(51) Int. Cl.: H05K 13/04

(54) **Zuführeinrichtung für gegurtete SMD-Bauelemente**
Feeder for belted SMD-components
Dispositif d'amenée de composants du type SMD insérés dans une bande

(30) Priorität: 21.09.1992 DE 4231572
(43) Veröffentlichungstag der Anmeldung: 30.03.1994
(73) Patentinhaber: SIEMENS AKTIENGESELLSCHAFT, D-80333 München (DE)
(72) Erfinder: Schulz, Ralf, Dipl.-Ing., D-80809 München (DE)

(56) Entgegenhaltungen:
- EP-A- 0 223 505
- EP-A- 0 460 834

## Beschreibung

Bei der automatischen Bestückung von Leiterplatten mit oberflächenmontierbaren Bauelementen, den sog. SMD-Bauelementen, erfolgt die Bereitstellung der Bauelemente über verschiedene Arten von Zuführeinrichtungen, wobei hier jedoch der Bereitstellung von gegurteten Bauelementen eine besondere Bedeutung zukommt. Die Anlieferform im Gurt (vgl. DIN IEC 286, Sept. 1987) ist besonders automatisierungsfreundlich, da die Bauelemente bereits vereinzelt sind und die Verpackung im Gurt weitgehende Sicherheit gegen Vertauschung gewährleistet. In den einzelnen Zuführeinrichtungen für gegurtete Bauelemente werden die Gurte mit den Bauelementen von einer Gurtspule abgespult und dann einer Entnahmeposition für die Bauelemente zugeführt. In dieser Entnahmeposition werden die Bauelemente dann mit der Saugpipette eines Bestückkopfes aufgenommen und sodann in einer vorgegebenen Bestückposition auf einer Leiterplatte positioniert. Die Abdeckfolien der Gurte, die ein Herausfallen der Bauelemente aus den Bauelementefachern verhindern, werden noch vor Erreichen der Entnahmeposition abgezogen und meist auf eine angetriebene Spule aufgewickelt (vgl. EP-A-0 013 979 und EP-A-0 016 368).

Aus der EP-A-0 223 505 ist eine Zuführeinrichtung für gegurtete SMD-Bauelemente mit einer beweglichen Abdeckung der Bauelementefächer im Entnahmebereich bekannt. Diese Abdeckung wird synchron mit dem Gurt in Abwickelrichtung des Gurtes bewegt, bis das vorderste noch gefüllte Bauelementefach die Entnahmeposition erreicht hat. Danach wird die Abdeckung zur Freigabe des vordersten Bauelementefaches in der Gegenrichtung bewegt. Der Antrieb der Abdeckung erfolgt hierbei durch deren Ankopplung an den eigentlichen Gurtantrieb. Zum Antrieb des Gurtes ist ein über Druckfedern in Abwickelrichtung bewegter Schieber vorgesehen, der über einen Hebel nach jedem Vorwärtshub wieder zurückgestellt wird. Die Hin- und Herbewegung des Schiebers wird auf eine Transportplatte übertragen, deren Transportstifte bei der Vorwärtsbewegung in die Transportlöcher des Gurtes eingreifen und bei der Rückwärtsbewegung zurückgezogen werden. Andererseits wird die Hin- und Herbewegung des Schiebers auch auf die Abdeckung übertragen, die in ihrem rückwärtigen Bereich einen U-förmigen Querschnitt aufweist und über die beiden seitlichen Schenkel und Mitnehmerstifte an den Schieber angekoppelt ist. Durch die bewegliche Abdeckung werden die SMD-Bauelemente im Entnahmebereich eines Gurtes während des Transports abgedeckt, d.h. ein Aufstellen der Bauelemente oder ein Herausspringen aus den Bauelementefächern wird verhindert.

Der im Anspruch 1 angegebenen Erfindung liegt das Problem zugrunde, bei einer Zuführeinrichtung für gegurtete SMD-Bauelemente eine mit geringem Aufwand angetriebene Abdeckung der Bauelementefächer im Entnahmebereich zu schaffen.

Die mit der Erfindung erzielten Vorteile bestehen insbesondere darin, daß die Abdeckung der Bauelemente in den Bauelementefächern keinen externen Antrieb benötigt und damit mit einem Minimum an baulichem Aufwand realisiert werden kann. Dieser Verzicht auf einen externen Antrieb wird durch den Mitnehmerstift ermöglicht, der die erforderliche Vorwärtsbewegung der Abdeckung an der Vorwärtsbewegung des Gurtes abgreift.

Vorteilhafte Ausgestaltungen der Erfindung sind in den Ansprüchen 2 bis 6 angegeben.

Die Ausgestaltung nach Anspruch 2 ermöglicht eine besonders einfache Rückstellung der Abdeckung mit Hilfe einer Rückstellfeder.

Die Ausgestaltung nach Anspruch 3 ermöglicht eine Anwendung der erfindungsgemäßen Abdeckung auch in solchen Fällen, in denen der Teilungsabstand zwischen den Transportlöchern des Gurtes 4 mm beträgt, während die Bauelementefächer in einem Teilungsabstand von nur 2 mm angeordnet sind. Gemäß Anspruch 4 sind dann die beiden Mitnehmerstifte vorzugsweise gefedert angeordnet, so daß der jeweils nicht im Eingriff stehende Mitnehmerstift ausweichen kann.

Die Weiterbildung nach Anspruch 5 ermöglicht eine einfache Verschiebung der Mitnehmerstifte beim Vorwärtstransport der Abdeckung mit Hilfe eines Schlittens, während die Ausgestaltung nach Anspruch 6 eine besonders einfache Rückstellung der Mitnehmerstifte mit Hilfe einer Rückstellfeder erlaubt.

Ein Ausführungsbeispiel der Erfindung ist in der Zeichnung dargestellt und wird im folgenden näher beschrieben.

Es zeigen:
Figur 1 eine Draufsicht auf einen Gurt im Entnahmebereich der Bauelemente,
Figur 2 die Anordnung einer Abdeckung auf dem Gurt gemäß Figur 1 während des Transportes des Gurtes,
Figur 3 die Anordnung der Abdeckung gemäß Figur 2 während des Stillstandes des Gurtes zur Bauteilentnahme und
Figur 4 das Antriebsprinzip der in den Figuren 2 und 3 dargestellten Abdeckung.

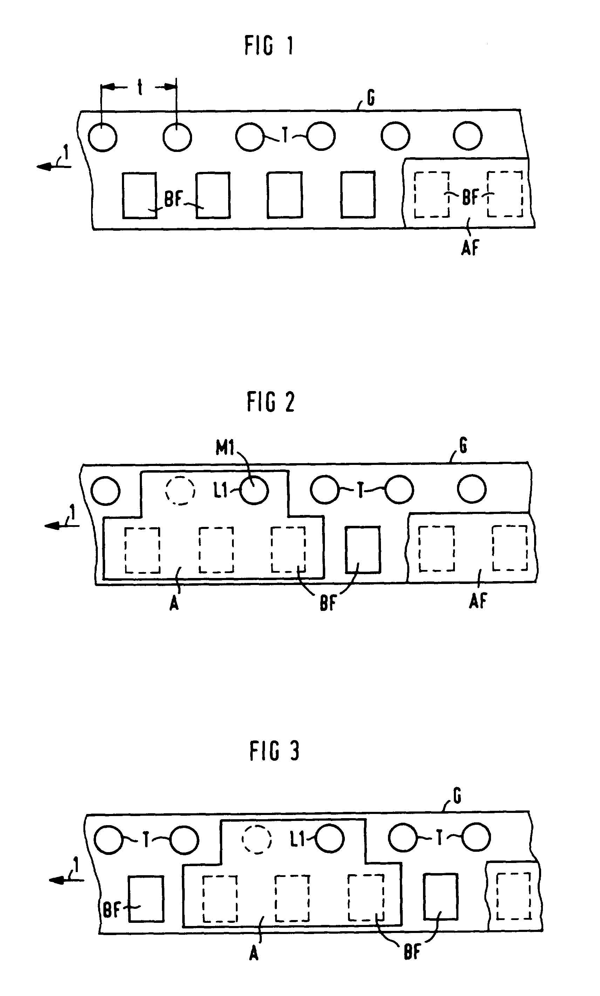

Figur 1 zeigt eine Draufsicht auf einen Teil eines insgesamt mit G bezeichneten Gurtes, dessen in einem Teilungsabstand von t = 4 mm angeordnete Transportlöcher mit T bezeichnet sind und dessen im gleichen Teilungsabstand angeordnete Bauelementefächer mit BF bezeichnet sind. Jedes Bauelementefach BF enthält ein in der Zeichnung nicht näher dargestelltes SMD-Bauelement. Das Herausfallen der SMD-Bauelemente aus dem Bauelementefach BF wird durch eine Abdeckfolie AF verhindert.

Der in Figur 1 dargestellte Gurt G wird in einer Zuführeinrichtung von einer Gurtspule abgespult und durch einen in die Transportlöcher T eingreifenden Antrieb schrittweise in Abwickelrichtung 1 einer Entnahmeposition zugeführt, in welcher die SMD-Bauelemente vom Bestückkopf eines Bestückungsautomaten aus dem jeweiligen Bauelementefach BF entnommen werden. Da die Abdeckfolie AF vor dem Erreichen der Entnahmeposition abgezogen werden muß, besteht die Gefahr, daß sich die SMD-Bauelemente im Entnahmebereich während des Transportes aufstellen oder aus dem Bauelementefach BF herausspringen. Dies wird durch eine in Figur 2 erkennbare flache Abdeckung A verhindert, die im dargestellten Ausführungsbeispiel drei Bauelementefächer BF abdeckt und synchron mit dem Gurt G in Abwickelrichtung 1 bewegt wird, bis das vorderste noch gefüllte Bauelementefach BF die Entnahmeposition erreicht hat. Die Ankoppelung der Abdeckung A an den Gurt G erfolgt durch einen Mitnehmerstift M1, der von unten her in ein Transportloch T und ein Loch L1 der Abdeckung A eingreift.

Nach Erreichen der Entnahmeposition wird der Mitnehmerstift M1 zurückgezogen und die Abdeckung A wird gemäß Figur 3 zur Freigabe des vordersten Bauelementefaches BF entgegengesetzt zur Abwickelrichtung 1 um einen Teilungsabstand t zurückgezogen.

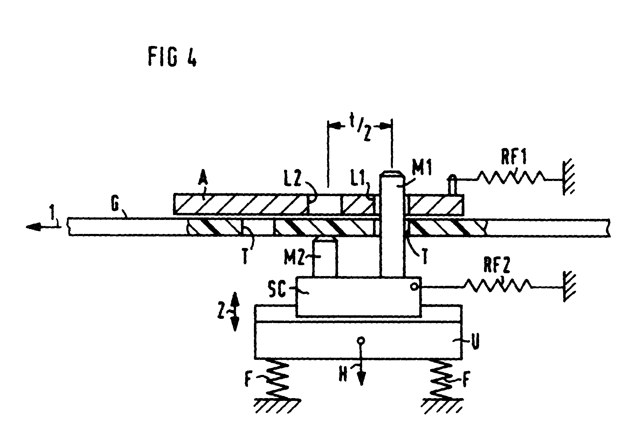

Figur 4 zeigt in stark vereinfachter schematischer Darstellung das Antriebsprinzip der in den Figuren 2 und 3 in der Draufsicht dargestellten Abdeckung A. Es ist zu erkennen, daß der bereits erwähnte Mitnehmerstift M 1 auf einem Schlitten SC angeordnet ist, dessen Unterteil mit U bezeichnet ist. Das auf Federn F gelagerte Unterteil U kann mit Hilfe einer lediglich durch einen Pfeil H angedeuteten Hubeinrichtung in vertikaler Richtung verstellt werden, so wie es durch einen Doppelpfeil 2 angedeutet ist. Im dargestellten angehobenen Zustand des Unterteils U greift der Mitnehmerstift M 1 in ein Transportloch T des Gurtes G und in das zugeordnete Loch L1 der Abdeckung A ein. Durch diese Ankopplung an den Gurt G kann die Abdeckung A in Abwickelrichtung 1 in die in Figur 2 dargestellte Lage bewegt werden. Danach wird der Mitnehmerstift M1 durch Betätigung der beispielsweise durch einen Hubmagneten gebildeten Hubeinrichtung H zurückgezogen und die Abdeckung A wird über eine Rückstellfeder RF1 in die in Figur 3 dargestellte Lage zurückgezogen. Gleichzeitig wird auch der Schlitten SC über eine Rückstellfeder RF2 zurückgezogen. Die Endlagen der Abdeckung A und des Schlittens SC werden dabei durch in Figur 4 nicht näher dargestellte Anschläge definiert.

Die bisherige Schilderung bezieht sich auf die in den Figuren 1 bis 3 dargestellten Gurte G, bei welchen der Teilungsabstand t zwischen den Transportlöchern T und den Bauelementefächern BF gleich ist. Bei Gurten G mit einer Teilung der Bauelementefächer BF, die dem halben Teilungsabstand t der Transportlöcher T entspricht, ist ein zweiter Mitnehmerstift M2 erforderlich, welchem ein zweites Loch L2 in der Abdeckung A zugeordnet ist. Der Abstand zwischen den Mitnehmerstiften M1 und M2 bzw. zwischen den Löchern L1 und L2 entspricht dabei dem halben Teilungsabstand t. Die beiden Mitnehmerstifte M1 und M2 sind dabei gefedert im Schlitten SC angeordnet, so daß der jeweils nicht im Eingriff stehende Mitnehmerstift M1 bzw. M2 ausweichen kann. Diese Ausweichlage ist in Figur 4 für den Mitnehmerstift M2 dargestellt. Durch alternierenden Eingriff der Mitnehmerstifte M1 und M2 wird dann eine Hin- und Herbewegung der Abdeckung A um den halben Teilungsabstand t der Transportlöcher T ermöglicht.

## Patentansprüche

1. Zuführeinrichtung für gegurtete SMD-Bauelemente, mit einer beweglichen Abdeckung (A) der Bauelementefächer (BF) im Entnahmebereich,
**dadurch gekennzeichnet**,
daß die Abdeckung (A)
- durch Eingriff eines Mitnehmerstiftes (M1, M2) in ein Transportloch (T) des Gurtes (G) und ein zugeordnetes Loch (L1, L2) der Abdeckung (A) in Abwickelrichtung (1) des Gurtes (G) bewegbar und
- durch Zurückziehen des Mitnehmerstiftes (M1, M2) zur Freigabe des jeweils vordersten Bauelementefaches (BF) in ihre Ausgangsstellung rückstellbar ist.

2. Zuführeinrichtung nach Anspruch 1,
**dadurch gekennzeichnet**,
daß zur Rückstellung der Abdeckung (A) eine Rückstellfeder (RF1) vorgesehen ist.

3. Zuführeinrichtung nach Anspruch 1 oder 2,
**dadurch gekennzeichnet**,
daß ein erster Mitnehmerstift (M1) und ein zweiter Mitnehmerstift (M2) vorgesehen sind, wobei der Abstand zwischen den beiden Mitnehmerstiften (M1, M2) und den zugeordneten Löchern (L1, L2) der Abdeckung (A) der halben Teilung (t) der Transportlöcher (T) des Gurtes (G) entspricht.

4. Zuführeinrichtung nach Anspruch 3,
**dadurch gekennzeichnet**,
daß die beiden Mitnehmerstifte (M1, M2) gefedert angeordnet sind.

5. Zuführeinrichtung nach Anspruch 3 oder 4,
**dadurch gekennzeichnet**,
daß die beiden Mitnehmerstifte (M1, M2) unterhalb des Gurtes (G) auf einem in Abwickelrichtung (1) verfahrbaren Schlitten (SC) angeordnet sind.

6. Zuführeinrichtung nach Anspruch 5,
**dadurch gekennzeichnet,**
daß zur Rückstellung des Schlittens (SC) in seine Ausgangslage eine Rückstellfeder (RF2) vorgesehen ist.

## Claims

1. Feeder for belted SMD components, having a movable cover (A) of the component compartments (BF) in the removal region, characterized in that the cover (A)
- can be moved in the unwind direction (1) of the belt (G) as a result of the engagement of a driver pin (M1, M2) in a transport hole (T) of the belt (G) and an associated hole (L1, L2) of the cover (A) and
- can be reset into its initial position by means of withdrawing the driver pin (M1, M2) to release the respectively frontmost component compartment (BF).

2. Feeder according to Claim 1, characterized in that a reset spring (RF1) is provided for resetting the cover (A).

3. Feeder according to Claim 1 or 2, characterized in that a first driver pin (M1) and a second driver pin (M2) are provided, the distance between the two driver pins (M1, M2) and the associated holes (L1, L2) of the cover (A) corresponding to half the division (t) of the transport holes (T) of the belt (G).

4. Feeder according to Claim 3, characterized in that both the driver pins (M1, M2) have a sprung arrangement.

5. Feeder according to Claim 3 or 4, characterized in that both the driver pins (M1, M2) are arranged underneath the belt (G) on a slide (SC) which can be driven in the unwind direction (1).

6. Feeder according to Claim 5, characterized in that a reset spring (RF2) is provided for resetting the slide (SC) into its initial position.

## Revendications

1. Dispositif d'amenée pour des composants CMS disposés sur une bande, comportant un élément mobile de recouvrement (A) des cases (BF) où sont logés les composants, dans la zone de prélèvement, caractérisé par le fait
que l'élément de recouvrement (A)
- peut être déplaçé dans le sens de déroulement (1) de la bande (G), par engagement d'une tige d'entraînement (M1,M2) dans un trou de transport (T) de la bande (G) et dans un trou associé (L1,L2) de l'élément de recouvrement (A),
- peut être ramené dans sa position initiale, par rétraction de la tige d'entraînement (M1,M2) pour libérer le compartiment la case la plus en avant (BF) où est logé un composant.

2. Dispositif d'amenée suivant la revendication 1, caractérisé par le fait qu'il est prévu un ressort de rappel (RF1) pour le rappel de l'élément de recouvrement (A).

3. Dispositif d'amenée suivant la revendication 1 ou 2, caractérisé par le fait qu'une première tige d'entraînement (M1) et une seconde tige d'entraînement (M2) sont prévues, la distance entre les deux tiges d'entraînement (M1,M2) et les trous associés (L1,L2) de l'élément de recouvrement (A) correspondant à la moitié du pas de répartition (t) des trous de transport (T) de la bande (G) .

4. Dispositif d'amenée suivant la revendication 3, caractérisé par le fait que les deux tiges d'entraînement (M1,M2) sont disposées en étant suspendues sur ressort.

5. Dispositif d'amenée suivant la revendication 3 ou 4, caractérisé par le fait que les deux tiges d'entraînement (M1,M2) sont disposées au-dessous de la bande (G) sur un chariot (SC) pouvant être déplacé dans le sens de déroulement (1).

6. Dispositif d'amenée suivant la revendication 5, caractérisé par le fait qu'il est prévu un ressort de rappel (RF2) pour le rappel du chariot (SC) dans sa position initiale.
